# EUROPEAN PATENT APPLICATION

(11) **EP 3 486 352 A1**
(43) Date of publication of application: **22.05.2019**
(21) Application number: 18203084.1
(22) Date of filing: 29.10.2018
(51) Int. Cl.: C23C 14/04, C23C 14/24, C23C 14/30, C23C 14/50, F01D 5/28

(54) **MESH COATING MASK AND METHOD OF DEPOSITING A COATING**

(30) Priority: 27.10.2017 US 201715796271
(71) Applicant: United Technologies Corporation, Farmington, CT 06032 (US)
(72) Inventor: QUINN, Jr., Timothy William, New Windsor, NY New York 12553 (US)
(74) Representative: Dehns

(57) **Abstract**

A coating deposition assembly (10) includes a substrate (12) having an outer surface with a contoured geometry, a mesh mask (16) having a plurality of apertures and being disposed over a subset of the outer surface of the substrate (12) and spaced apart from the outer surface, and a tool (14) secured to the substrate (12). The tool (14) is configured to move the substrate (12) and the mesh mask (16) relative to a coating material source such that the mesh mask (16) maintains a fixed spatial relationship with the substrate (12).

## Description

### BACKGROUND

The present invention relates generally to a method of depositing a coating and, more particularly, to use of a coating deposition assembly including a mesh mask used to control coating thickness. Protective coatings are routinely applied to components subject to environmental damage or wear. Environmental barrier coatings and thermal barrier coatings are routinely used in aerospace applications. Environmental barrier coatings and thermal barrier coatings are commonly applied to blades and vanes of gas turbine engines, as well as other components susceptible to environmental damage (e.g., combustors and turbine blade outer air seals). Many of these components, particularly blades and vanes, have complex surface geometries, which present a challenge for producing desired coating distributions. Deposition rates can vary across differing surface regions, which can result in varying coating thicknesses. Excessive coating thicknesses can adversely increase the weight of the component and risk of spallation due to reduced adhesion strength. Additionally, aerodynamic geometry is tuned for optimal coating thickness.

Shadowing methods have been used to control excess coating deposition. Shadow masks can be moved across a surface to alter the line-of-sight or orientation of the substrate with respect to the coating source. These methods have limitations. They can require complicated tooling setups and have been found to adversely affect the microstructure of thermal barrier coatings. For instance, use of shadow masks can disrupt columnar growth in coatings deposited using electron beam-physical vapor depositions (EB-PVD) and cause breaks in columns, which can adversely impact the mechanical and thermal properties of the coatings. There is a need for a method to limit coating deposition in certain regions of a component with a complex surface geometry without adversely altering the coating microstructure.

### SUMMARY

In one aspect, a coating deposition assembly includes a substrate having an outer surface with a contoured geometry, a mesh mask having a plurality of apertures and being disposed over a subset (or 'portion') of the outer surface of the substrate and spaced apart from the outer surface, and a tool secured to the substrate. The tool is configured to move the substrate and the mesh mask relative to a coating material source such that the mesh mask maintains a fixed spatial relationship with the substrate.

In another aspect, a method of depositing a coating on a substrate having a an outer surface with a contoured geometry includes securing the substrate to a tool configured to move the substrate relative to a coating material source, positioning a mesh mask with a plurality of apertures over a subset (or 'portion') of the outer surface of the substrate, securing the mesh mask in a fixed position relative to the substrate, placing the substrate and mesh mask adjacent the coating material source, passing the coating material through the apertures of the mesh mask, and depositing the coating material on the subset of the outer surface. The mesh mask is spaced apart from the substrate and the substrate and mesh mask maintain a fixed spatial relationship during deposition.

The present summary is provided only by way of example, and not limitation. Other aspects of the present disclosure will be appreciated in view of the entirety of the present disclosure, including the entire text, claims and accompanying figures.

### BRIEF DESCRIPTION OF THE DRAWINGS

FIG. 1 is a perspective view of a coating deposition assembly.
FIG. 2 is a perspective top view of another coating deposition assembly.
FIG. 3 is a schematic view of a coating deposition system including the coating deposition assembly of FIG. 1 and/or FIG. 2.
FIG. 4A is schematic view of a mesh mask of the coating deposition assembly of FIG. 1 and/or FIG. 2.
FIGS. 4B-4D are schematic views of the mesh mask of FIG. 4A being partially coated. The amount of coating on the mesh mask increases from FIG. 4B to FIG. 4D.

While the above-identified figures set forth embodiments of the present invention, other embodiments are also contemplated, as noted in the discussion. In all cases, this disclosure presents the invention by way of representation and not limitation. It should be understood that numerous other modifications and embodiments can be devised by those skilled in the art, which fall within the scope of the invention. The figures may not be drawn to scale, and applications and embodiments of the present invention may include features, steps and/or components not specifically shown in the drawings.

### DETAILED DESCRIPTION

Articles with complex geometries can present a challenge for producing desired coating distributions. In some instances, coating material must be reduced or increased to meet zone-specific thickness requirements. For example, components subject to aerodynamic constraints can require varying the coating thicknesses in different areas (e.g., suction side versus pressure side of an airfoil) to achieve optimal aerodynamic geometry. A mesh mask can be used to reduce an amount of coating material that reaches a surface of a component during deposition. When kept in a fixed spaced-apart relationship (not necessarily uniform spacing) with a portion of the outer surface of the component, the mesh mask can reduce a coating thickness on the portion of the outer surface that is masked, while permitting formation of a coating microstructure consistent with non-masked portions of the outer surface. In other words, the mesh mask can reduce the coating thickness in the affected area without modifying the coating microstructure.

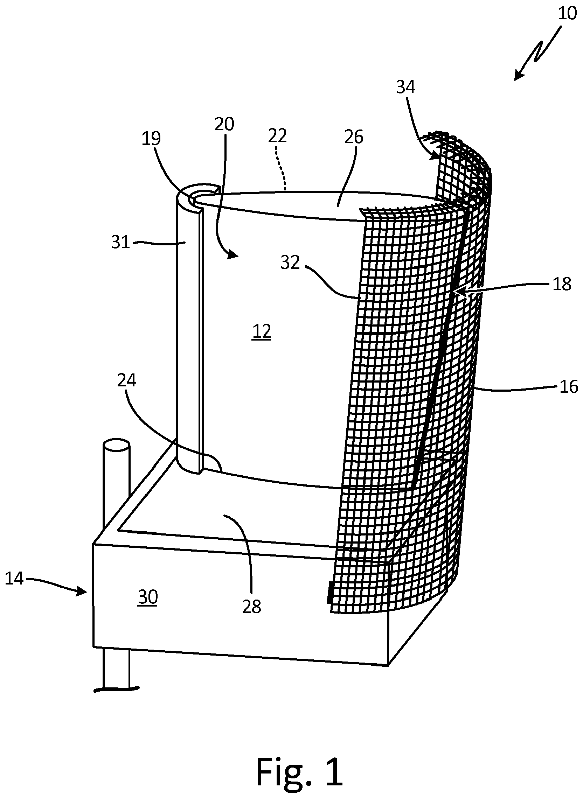

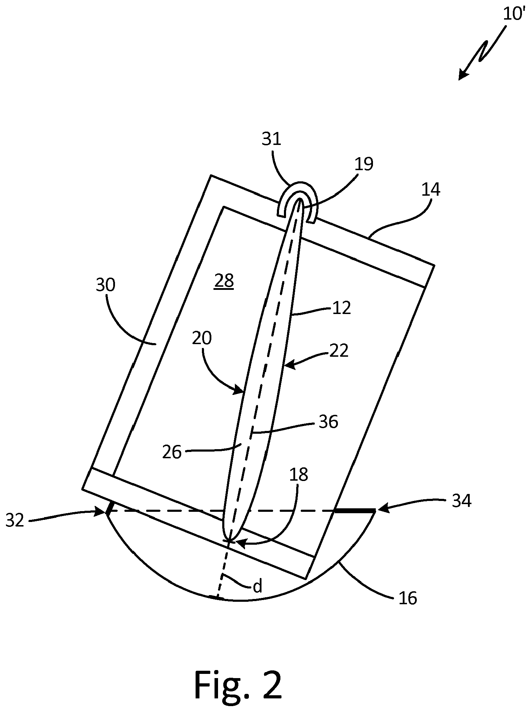

FIGS. 1 and 2 are side and top perspective views, respectively, of coating deposition assemblies 10 and 10'. FIGS. 1 and 2 show component or substrate 12, tool 14, and mesh mask 16. Both component 12 and mesh mask 16 can be secured to tool 14 for coating deposition. Component 12 can have an outer surface with a contoured geometry and multiple sides or faces. Tool 14 can be mounted to an apparatus (not shown) capable of changing an orientation of component 12, in combination with mesh mask 16, relative to a coating material source (not shown). The apparatus and tool 14 can be configured to allow component 12, in combination with mesh mask 16, to rotate and tilt relative to the coating material source to evenly distribute coating over the outer surface of component 12. Multiple tools can be mounted to a single apparatus (e.g., a rake) as known in the art, to simultaneously deposit coatings on multiple components 12.

In the embodiment shown in FIGS. 1 and 2, component 12 is an airfoil. Airfoil 12 has leading edge 18, trailing edge 19, suction side 20, pressure side 22, base 24 (FIG. 1 only), and tip 26. As shown in FIGS. 1 and 2, airfoil 12 can have an integral platform 28, which can be secured in mount 30 of tool 14. Some embodiments can also include solid mask 31 over trailing edge 19 to prevent coating deposition along trailing edge 19 as may be desirable. During coating deposition, the orientation of airfoil 12 with respect to the coating material source can be precisely modified to control coating deposition. Although changing the orientation of airfoil 12 with respect to the material coating source can encourage uniform or desired coating distribution over the contoured outer surface, increased deposition can occur along leading edge 18 if mesh mask 16 is not present. The increased coating deposition can result in an undesirable increased coating thickness along leading edge 18.

Mesh mask 16 can be curved over leading edge 18, such that mesh mask 16 at least partially separates airfoil 12 from coating material source, to reduce coating deposition along leading edge 18. As shown in FIGS. 1 and 2, mesh mask 16 is spaced apart from airfoil 12. Mesh mask 16 can extend from edge 32, which is proximate to suction side 20, to edge 34, which is proximate to pressure side 22, and can be curved to form an arc between edges 32 and 34 to mask leading edge 18. Mesh mask 16 can extend a full span of airfoil 12 from base 24 to tip 26. In some embodiments, mesh mask 16 can also extend over a portion of tip 26 to prevent excessive coating deposition in this area as may be required (FIG. 1). As shown in FIG. 1, edges 32 and 34 of mesh mask 16 can be secured to tool 14 at mount 30. In FIG. 1, edges 32 and 34 are secured to opposite sides of mount 30; whereas, in FIG. 2, edges 32 and 34 are secured to adjacent sides of mount 30. Mesh mask 16 can be secured to other areas of tool 14 and other locations of mesh mask 16 can be secured to tool 14. Mesh mask 16 can be secured by a tack weld or other fastening means as known in the art. Mesh mask 16 can be secured to tool 14 in a manner that allows mesh mask 16 to maintain a fixed spatial relationship with airfoil 12 during coating deposition.

During a coating deposition process, mesh mask 16 can separate airfoil 12 from the coating material source when tool 14 is oriented to position mesh mask 16 between the material source and airfoil 12. Openings in mesh mask 16 allow some passage of the coating material and deposition on the outer surface of airfoil 12. Over time, coating material can build up on mesh 16 and can begin to fill the openings. As the size of the openings is reduced, less coating material is allowed to pass through mesh mask 16, resulting in reduced coating deposition on the outer surface of airfoil 12. Eventually, the coating material deposited on mesh mask 16 can fully block the openings, preventing further deposition on the outer surface of airfoil 12 obstructed by mesh mask 16. In order to limit the effect of mesh mask 16 to leading edge 18, edges 32 and 34 of mesh mask 16 extend only slightly beyond leading edge 18, as viewed from the top in FIG. 2. In some embodiments, positions of edges 32 and 34 adjacent tip 26 correspond to locations at tip 26 that are less than 20 percent of a chord length 36 extending from leading edge 18. In some embodiments, edges 32 and 34 can be separated from airfoil 12 by a standoff distance that is greater than a standoff distance (d) at leading edge 18. In alternative embodiments, edge 32 can extend to cover a larger portion of suction side 20 of airfoil 12 to limit coating deposition along suction side 20 as may be needed for optimized aerodynamics (not shown). The separation between edges 32 and 34 can allow coating material to reach leading edge 18 without going through mesh mask 18 when airfoil 12 is oriented with respect to the coating material source such that there is a direct line-of-sight between the coating material source and leading edge 18. Therefore, mesh mask 16 only limits deposition on leading edge 18 when mesh mask 16 is positioned between the coating material source and leading edge 18.

In the embodiments shown in FIGS. 1 and 2, mesh mask 16 can be spaced apart from leading edge 18 by a standoff distance (d) of less than one inch (25.4 millimeters) at a location where mesh mask 16 and leading edge 18 are in closest proximity (shown in FIG. 2). In some embodiments, mesh mask 16 is spaced apart from leading edge 18 by approximately 0.65 inches (16.5 millimeters). In some embodiments, mesh mask 16 can be angled toward leading edge 18 such that the standoff distance (d) varies along the span of airfoil 12, tapering toward tip 26 to reduce coating deposition in the area of tip 26. As will be discussed further, material deposition through mesh mask 16 can increase with increasing standoff distance. While the standoff distance between mesh mask 16 and airfoil 12 can vary, mesh mask 16 remains in a fixed spatial relationship with airfoil 12 during coating deposition. It will be understood by one of ordinary skill in the art to vary the standoff distance to achieve a desired coating thickness.

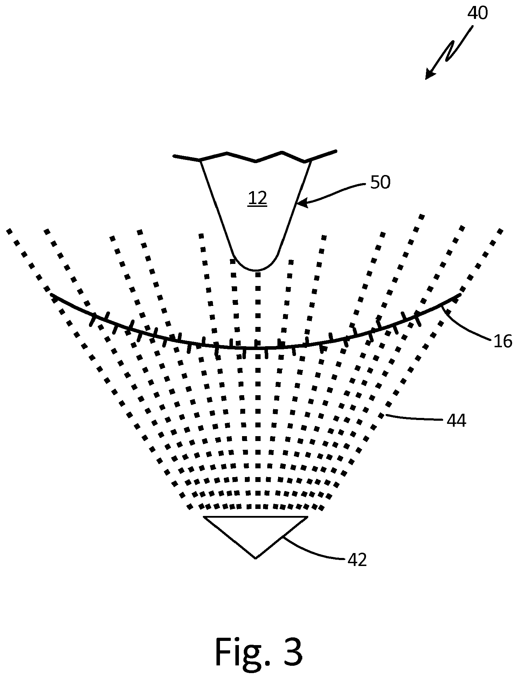

FIG. 3 provides a schematic view of coating deposition system 40, in which mesh mask 16 is spaced between substrate 12 and coating material source 42. FIG. 3 illustrates how some of coating material 44 is allowed to pass through openings in mesh mask 16 and coat the outer surface of airfoil 12, while some material 44 is effectively blocked by mesh mask 16 and prevented from coating the outer surface of airfoil 12. As will be discussed further, some material 44 coats mesh mask 16 and decreases the size of the openings in mesh mask 16. Although mesh mask 16 is particularly suited for EB-PVD processes, it will be understood by one of ordinary skill in the art that mesh mask 16 can be adapted for use in other deposition processes, not limited to plasma or thermal spray processes. Mesh mask 16 can be disposable. Mesh mask 16 and component 12 can be removed from tool 14 following coating deposition and can be replaced with a new mesh mask 16 and component 12. While mesh mask 16 has been described for use in coating an airfoil, it will be understood by one of ordinary skill in the art that mesh mask 16 can be used for coating a variety of components as well as other areas of a blade (e.g., platform).

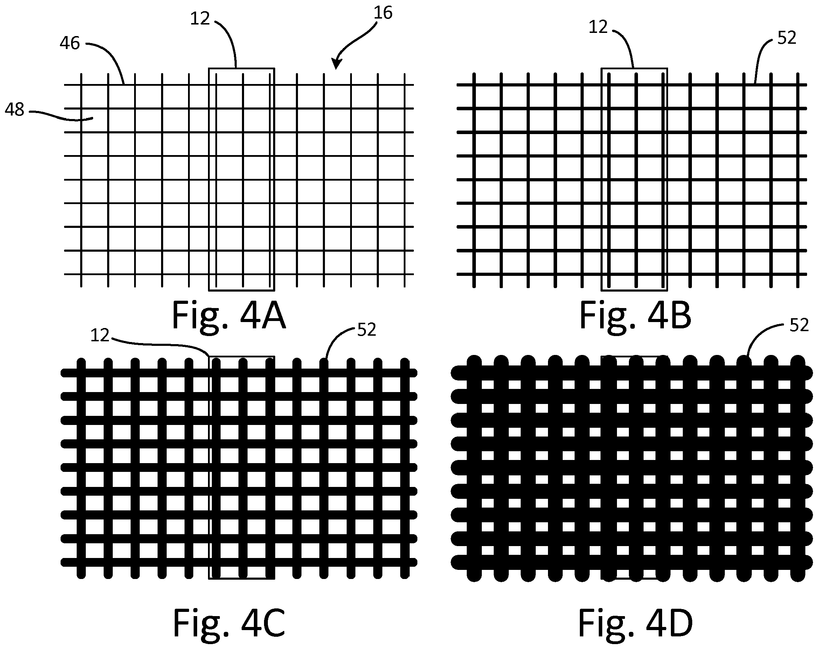

FIG. 4A is a schematic view of mesh mask 16 over a subset of the outer surface of component 12. Mesh mask 16 can be a fine mesh made of metal wire 46 having a diameter of 0.009 inches (0.23 millimeters) and forming a square mesh pattern with openings 48 of approximately 0.022 square inches (14.2 square millimeters). The standoff distance (d) between mesh mask 16 and the subset of component 12 can generally range from 0.2 inches to 1.0 inches (5.08-25.4 millimeters). In general, as standoff distance (d) is increased, additional material 44 is able to reach component 12, forming a thicker coating 50 on component 12. It can be advantageous to vary the standoff distance (d) over different areas of component 12 to increase or decrease material deposition as needed in different areas of component 12. It will be understood by one of ordinary skill in the art to modify the mesh size (wire gauge and/or opening size) and distance from component 12 to achieve a desirable coating thickness.

As disclosed, mesh mask can limit material deposition on the outer surface of component 12 along the subset of the outer surface masked without altering the coating microstructure (e.g., porosity, grain growth and orientation, etc.) as compared to non-masked coatings and while allowing formation of a coating (e.g., coating 50, shown in FIG. 3) having a generally uniform material distribution along the region of the outer surface obstructed by mesh mask 16. The combination of the fixed spatial relationship between mesh mask 16 and component 12 and the continuous change in orientation with respect to coating material source 42 can promote uniform material distribution. In the embodiments disclosed, mesh mask 16 does not produce a coating pattern or gridding on the outer surface of component 12, i.e., the coating is not thicker in areas corresponding to openings 48 in mesh mask 16, which allow passage of material 44. Because component 12 and mesh mask 16 are rotated and tilted simultaneously while maintaining a fixed spatial relationship with one another, the line-of-sight is continuously varied between coating material source 42 (shown in FIG. 3) and component 12. Therefore, a trajectory of material 44 (shown in FIG. 3) is continuously being changed with respect to mesh mask 16 and component 12, such that material 44 enters openings 48 at varying angles depending on the orientation of mesh mask 16 with respect to coating material source 42 thereby providing generally even material distribution along the outer surface. As used herein, the terms "uniform" and "even" material distribution refer to the absence of a surface pattern (i.e., gridding), not a thickness of the coating, which can vary depending on the standoff distance and deposition time. In some embodiments, coating time and orientation of component 12 and mesh mask 16 relative to coating material source 42 can be controlled to increase a rate of deposition at different locations on the outer surface of component 12. This can be done to achieve desired thicknesses at particular locations of the outer surface. Due to variations in deposition time depending on how component 12 is rotated or tilted with respect to the coating material source, the coating formed on the subset of the component masked can have a thickness approximately equal to a thickness of the coating formed on an adjacent subset of the outer surface where material deposition is unobstructed by mesh mask 16.

FIGS. 4B-4D are schematic views of mesh mask 16 being partially coated over time. As previously discussed, some material 44 can be deposited on wire 46 forming coating 52 on mesh mask 16. Over time, coating 52 builds up as more and more material 44 impacts mesh mask 16 or previously deposited material 44 thereon. As shown in FIGS. 4B-4D, the amount of coating 52 increases over time and begins to fill openings 48. Eventually, openings can be fully closed, blocking further passage of coating material 44 through mesh 16. As passage of coating material 44 though mesh mask 16 is reduced, coating deposition along the subset of the component masked is reduced. In this manner, mesh mask 16 controls a maximum thickness of the coating on the subset of component 12 masked and prevents an excessive buildup of coating material that could otherwise occur in the absence of mesh mask 16. In the embodiments disclosed, mesh mask 16 effectively reduced the coating thickness to 33%-75% of standard non-masked values.

Some embodiments can include a multi-part coating system, where a layer of one material is deposited over a layer of another material of differing material composition. In such embodiments, mesh mask 16 can remain in place during the deposition process or can be removed or replaced before the deposition of a different material. When mesh mask 16 remains in place during deposition of multiple coatings, deposition of the outermost coating can be reduced by mesh mask 16 to a greater extent than deposition of the innermost coating over the same period of time because openings 48 can have already been narrowed, limiting passage of material 44, before deposition of the outermost coating has begun.

Mesh mask 16 can be used to control the amount of coating material that reaches a surface of a component during material deposition. As disclosed herein, when mesh mask 16 is kept in a fixed spaced apart relationship with a portion of the outer surface of component 12, the mesh mask can reduce a coating thickness on the portion of the outer surface that is masked while producing a coating microstructure consistent with non-masked portions of the outer surface.

### Summation

Any relative terms or terms of degree used herein, such as "substantially", "essentially", "generally", "approximately" and the like, should be interpreted in accordance with and subject to any applicable definitions or limits expressly stated herein. In all instances, any relative terms or terms of degree used herein should be interpreted to broadly encompass any relevant disclosed embodiments as well as such ranges or variations as would be understood by a person of ordinary skill in the art in view of the entirety of the present disclosure, such as to encompass ordinary manufacturing tolerance variations, incidental alignment variations, transient alignment or shape variations induced by thermal, rotational or vibrational operational conditions and the like. Moreover, any relative terms or terms of degree used herein should be interpreted to encompass a range that expressly includes the designated quality, characteristic, parameter or value, without variation, as if no qualifying relative term or term of degree were utilized in the given disclosure or recitation.

### Discussion of Possible Embodiments

The following are non-exclusive descriptions of possible embodiments of the present invention.

A coating deposition assembly includes a substrate having an outer surface with a contoured geometry, a mesh mask having a plurality of apertures and being disposed over a subset (or portion) of the outer surface of the substrate and spaced apart from the outer surface, and a tool secured to the substrate. The tool is configured to move the substrate and the mesh mask relative to a coating material source such that the mesh mask maintains a fixed spatial relationship with the substrate.

The coating deposition assembly of the preceding paragraph can optionally include, additionally and/or alternatively, any one or more of the following features, configurations and/or additional components:
The coating deposition assembly of the preceding paragraph, wherein the mesh mask is spaced apart from the subset of the outer surface by a distance of less than one inch (25.4 millimeters).

The coating deposition assembly of any of the preceding paragraphs, wherein the mesh mask is a wire mesh having a square pattern.

The coating deposition assembly of any of the preceding paragraphs, wherein the wire has a diameter of approximately 0.009 inches (0.23 millimeters) and the apertures have an opening size of approximately 0.022 square inches (0.56 square millimeters).

The coating deposition assembly of any of the preceding paragraphs, wherein the mesh mask is secured to the tool.

The coating deposition assembly of any of the preceding paragraphs, wherein the substrate is an airfoil.

The coating deposition assembly of any of the preceding paragraphs, wherein the subset of the outer surface comprises a leading edge of the airfoil.

The coating deposition assembly of any of the preceding paragraphs, wherein the mesh mask extends from a first edge proximate to a suction side of the airfoil to a second edge proximate to a pressure side of the airfoil.

The coating deposition assembly of any of the preceding paragraphs, wherein the mesh mask is curved to form an arc between the first and second edges.

The coating deposition assembly of any of the preceding paragraphs, wherein the mesh mask extends a full span of the airfoil from a base of the airfoil to a tip of the airfoil.

A method of depositing a coating on a substrate having a an outer surface with a contoured geometry includes securing the substrate to a tool configured to move the substrate relative to a coating material source, positioning a mesh mask having a plurality of apertures over a subset (or portion) of the outer surface of the substrate, securing the mesh mask in a fixed position relative to the substrate, placing the substrate and mesh mask adjacent the coating material source, passing the coating material through the apertures of the mesh mask, and depositing the coating material on the subset of the outer surface. The mesh mask is spaced apart from the substrate and the substrate and mesh mask maintain a fixed spatial relationship during deposition.

The method of the preceding paragraph can optionally include, additionally and/or alternatively, any one or more of the following features, configurations, additional components, and/or steps:
The method of the preceding paragraph and further including depositing the coating on the mesh mask and reducing an opening size of the apertures.

The method of any of the preceding paragraphs, wherein the substrate is an airfoil and positioning the mesh mask comprises curving the mesh mask over a leading edge of the airfoil such that the mesh mask extends in an arc from a suction side of the airfoil to a pressure side of the airfoil.

The method of any of the preceding paragraphs, wherein positioning the mesh mask includes extending the mesh mask along a full span of the airfoil from a base of the airfoil to a tip of the airfoil.

The method of any of the preceding paragraphs, wherein positioning the mesh mask includes extending the mesh mask over at least a portion of the tip of the airfoil.

The method of any of the preceding paragraphs and further including rotating the substrate and mesh mask in the fixed spatial relationship, wherein rotating the substrate and mesh mask includes varying the position of the substrate and mesh mask relative to the coating material source.

The method of any of the preceding paragraphs and further including tilting the substrate and mesh mask in the fixed spatial relationship, wherein tilting the substrate and mesh mask includes varying the position of the substrate and mesh mask relative to the coating material source.

The method of any of the preceding paragraphs, wherein depositing the coating material on the subset of the outer surface includes forming a coating having generally uniform material distribution.

The method of any of the preceding paragraphs, wherein depositing the coating material on the subset of the outer surface includes forming a coating on the subset of the surface having a thickness approximately equal to a thickness of a coating formed on an adjacent subset of the outer surface of the substrate where coating deposition is unobstructed by the mesh mask.

The method of any of the preceding paragraphs, wherein the coating is deposited using physical vapor deposition.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A coating deposition assembly (10;10') comprising:
a substrate (12) having an outer surface with a contoured geometry;
a mesh mask (16) comprising a plurality of apertures (48), wherein the mesh mask (16) is disposed over a subset of the outer surface and spaced apart from the outer surface; and
a tool (14) secured to the substrate (12), wherein the tool (14) is configured to move the substrate (12) and the mesh mask (16) relative to a coating material source (42) such that the mesh mask (16) maintains a fixed spatial relationship with the substrate (12).

2. The coating assembly (10;10') of claim 1, wherein the mesh mask (16) is spaced apart from the subset of the outer surface by a distance (d) of less than one inch (25.4 millimeters).

3. The coating assembly (10;10') of claim 1 or 2, wherein the mesh mask (16) comprises a wire mesh having a square pattern, optionally wherein the wire (46) of the wire mesh has a diameter of approximately 0.009 inches (0.23 millimeters) and/or the apertures (48) have an opening size of approximately 0.022 square inches (14.2 square millimeters).

4. The coating assembly (10;10') of any of claims 1 to 3, wherein the mesh mask (16) is secured to the tool (14).

5. The coating assembly (10;10') of any preceding claim, wherein the substrate (12) comprises an airfoil (12).

6. The coating assembly (10;10') of claim 5, wherein the subset of the outer surface comprises a leading edge (18) of the airfoil (12).

7. The coating assembly (10;10') of claim 5 or 6, wherein the mesh mask (16) extends from a first edge (32) proximate to a suction side (20) of the airfoil to a second edge (34) proximate to a pressure side (22) of the airfoil (12).

8. The coating assembly (10;10') of claim 7, wherein the mesh mask (16) is curved to form an arc between the first and second edges (32,34).

9. The coating assembly (10;10') of any of claims 5 to 8, wherein the mesh mask (16) extends a full span of the airfoil (12) from a base (24) of the airfoil (12) to a tip (26) of the airfoil (12).

10. A method of depositing a coating (50) on a substrate (12) having an outer surface with a contoured geometry, the method comprising:
securing the substrate (12) to a tool (14) configured to move the substrate (12) relative to a coating material source (42);
positioning a mesh mask (16) over a subset of the outer surface of the substrate (12), wherein the mesh mask (16) has a plurality of apertures (48);
securing the mesh mask (16) in a fixed position relative to the substrate (12), wherein the mesh mask (16) is spaced apart from the substrate (12) and the substrate (12) and mesh mask (16) maintain a fixed spatial relationship during deposition;
placing the substrate (12) and mesh mask (16) adjacent the coating material source (42);
passing coating material (44) through the apertures (48) of the mesh mask (16); and
depositing the coating material (44) on the subset of the outer surface.

11. The method of claim 10 and further comprising:
depositing the coating (52) on the mesh mask, optionally using physical vapor deposition; and
reducing an opening size of the apertures (48).

12. The method of claim 10 or 11, wherein the substrate (12) comprises an airfoil (12) and positioning the mesh mask (16) comprises curving the mesh mask (16) over a leading edge (18) of the airfoil (12) such that the mesh mask (16) extends in an arc from a suction side (20) of the airfoil (12) to a pressure side (22) of the airfoil (12).

13. The method of claim 12, wherein positioning the mesh mask (16) comprises extending the mesh mask (16) along a full span of the airfoil (12) from a base (24) of the airfoil (12) to a tip (26) of the airfoil (12), wherein positioning the mesh mask (16) optionally comprises extending the mesh mask (16) over at least a portion of the tip (26) of the airfoil (12).

14. The method of any of claims 10 to 13, and further comprising rotating and/or tilling the substrate (12) and mesh mask (16) in the fixed spatial relationship, wherein rotating and/or tilling the substrate (12) and mesh mask (16) comprises varying the position of the substrate (12) and mesh mask (16) relative to the coating material source (42).

15. The method of any of claims 10 to 14, wherein depositing the coating material (44) on the subset of the outer surface comprises:
forming a coating (50) having generally uniform material distribution; and/or
forming a coating (50) on the subset of the surface having a thickness approximately equal to a thickness of a coating (50) formed on an adjacent subset of the outer surface of the substrate (12) where coating deposition is unobstructed by the mesh mask (16).
